# EUROPÄISCHE PATENTSCHRIFT

(11) **EP 2 617 133 B1**
(45) Veröffentlichungstag und Bekanntmachung des Hinweises auf die Patenterteilung: **28.03.2018**
(21) Anmeldenummer: 11760445.4
(22) Anmeldetag: 13.09.2011
(51) Int. Cl.: H03K 17/96, H01H 9/02, B29C 45/16, H01H 11/00

(54) **SCHALTERGEHÄUSE FÜR KAPAZITIVE SCHALTER**
SWITCH HOUSING FOR CAPACITIVE SWITCHES
BOÎTIER DE COMMUTATEUR POUR COMMUTATEUR CAPACITIF

(30) Priorität: 13.09.2010 DE 102010045199
(43) Veröffentlichungstag der Anmeldung: 24.07.2013
(73) Patentinhaber: TRW Automotive Electronics & Components GmbH, 78315 Radolfzell (DE)
(72) Erfinder: KOBERSTEIN, Udo, 89345 Moos (DE)
(74) Vertreter: Prinz & Partner mbB
(86) Internationale Anmeldenummer: PCT/EP2011/065819
(87) Internationale Veröffentlichungsnummer: WO 2012/034994

(56) Entgegenhaltungen:
- EP-A1- 2 106 026
- EP-A2- 0 208 087
- DE-A1- 10 118 487
- US-A- 5 917 165
- US-A- 6 110 576
- US-A1- 2005 205 407

## Beschreibung

Die Erfindung betrifft ein Schaltergehäuse für kapazitive Schalter, ein Schaltergehäuse, das integrierte elektrisch leitfähige Elektrodenstrukturen aufweist, und einen mit dem Schaltergehäuse ausgestatteten kapazitiven Schalter.

Kapazitive Schalter bestehen prinzipiell aus einer flachen Elektrode auf der einen Seite einer Schicht aus dielektrischem Material, deren davon abgewandte Fläche eine Berührungsfläche bildet. Schaltergehäuse für kapazitive Schalter werden gewöhnlich aus Kunststoff hergestellt. Die Frontfläche des Schaltergehäuses bildet die Berührungsfläche, und die dieser gegenüberliegende Fläche auf der Innenseite des Schaltergehäuses trägt eine elektrisch leitende Elektrodenstruktur. Derartige Elektrodenstrukturen können als leitfähige Schichten mit sogenanntem Leitlack oder anderen elektrisch leitfähigen Materialien auf dem elektrisch nicht leitenden Kunststoff des Schaltergehäuses aufgebracht werden. Mit üblichen Beschichtungsverfahren können nur dünne Schichten aufgebracht werden. Die benötigen Elektrodenstrukturen können von komplexer Gestalt sein, sodass spezielle Beschichtungsverfahren benötigt werden. Für die sichere Kontaktierung der Elektrodenstrukturen werden präzise 3D-Strukturen benötigt, die mit einem Beschichtungsverfahren nur schwer erreichbar sind. Für Anwendungen im Automobilbereich sind herkömmliche Beschichtungslösungen zudem mechanisch anfällig und korrosionsgefährdet.

Die US 2005/205407 A1 offenbart ein Schaltergehäuse für kapazitive Schalter mit einer äußeren Berührungsfläche und innenseitig in Gegenüberlage zu der Berührungsfläche angeordneten flachen Elektrodenstrukturen. Die Elektrodenstrukturen sind im Zweikomponenten-Spritzguss in ausgesparte Bereiche des aus einer ersten, elektrisch nicht leitfähigen Kunststoffkomponente gespritzten Gehäusekörpers mit einer zweiten, elektrisch leitfähigen Kunststoffkomponenten eingebrach. Die flachen Elektrodenstrukturen sind mit angeformten Kontaktfahnen ausgebildet, die zu einem auf der Innenseite des Gehäusekörpers angeformten Kontaktierungsblock durch den Gehäusebereich geführt sind.

Die DE 101 18 487 A1 offenbart, dass zwei Kunststoffkomponenten des Spritzguss-Verfahrens ein Polycarbonat sein können, von denen die eine Kunststoffkomponente Kohlefasern enthält.

Durch die Erfindung wird ein eine Berührungsfläche aufweisendes Schaltergehäuse für kapazitive Schalter durch Zweikomponenten-Spritzguss geschaffen. Mit einer ersten, elektrisch isolierenden Kunststoffkomponente wird zunächst ein Gehäusekörper gespritzt, der auf der Innenseite in Gegenüberlage zu der Berührungsfläche ausgesparte Bereiche aufweist. Dann wird in die ausgesparten Bereiche eine zweite, elektrisch leitfähige Kunststoffkomponente gespritzt, die das gleiche Basismaterial wie die erste Kunststoffkomponente enthält, beispielsweise ein Polycarbonat. Die Leitfähigkeit der zweiten Kunststoffkomponente ergibt sich durch Beimischung von leitfähigen Partikeln wie Kohlefasern. Die mit der elektrisch leitfähigen Kunststoffkomponente gespritzten Strukturen können von beliebiger Komplexität sein und eine ausreichende Dicke haben, um eine hohe mechanische Festigkeit zu gewährleisten. Die so geschaffenen Elektrodenstrukturen gehen einen innigen Verbund mit der ersten, elektrisch nicht leitfähigen Kunststoffkomponente ein, da beide Kunststoffkomponenten das gleiche Basismaterial haben.

Das durch die Erfindung geschaffene Schaltergehäuse für kapazitive Schalter hat eine äußere Berührungsfläche und innenseitig in Gegenüberlage zu der Berührungsfläche angeordnete flache Elektrodenstrukturen, die im Zweikomponenten-Spritzguss in innenseitig in Gegenüberlage der Berührungsfläche angeordnete, ausgesparte Bereiche des aus einer ersten, elektrisch nicht leitfähigen Kunststoffkomponente gespritzten Gehäusekörpers mit einer zweiten, elektrisch leitfähigen Kunststoffkomponente eingebracht sind. Vorzugsweise handelt es sich bei beiden Kunststoffkomponenten um ein Polycarbonat, wobei die zweite Kunststoffkomponente Kohlefasern enthält.

Die flachen Elektrodenstrukturen haben ausgesparte Fenster, und die Berührungsfläche gegenüber den ausgesparten Fenstern ist lichtdurchlässig. Der mit diesem Schaltergehäuse ausgestattete erfindungsgemäße Schalter hat auf der Berührungsfläche des Schaltergehäuses angeordnete Symbole, die durch die ausgesparten Fenster der Elektrodenstrukturen und durch verdünnte Wandungsbereiche des Schaltergehäuses hindurch beleuchtet werden können.

Die flachen Elektrodenstrukturen sind mit angeformten Kontaktfahnen ausgebildet, die zu einem auf der Innenseite des Gehäusekörpers angeformten Kontaktierungsblock geführt sind; der Kontaktierungsblock weist Ausnehmungen auf, in denen die Enden der Kontaktfahnen positioniert sind und mit der Oberfläche des Kontaktierungsblocks bündige Kontaktierungsflächen bilden. Es ist daher problemlos möglich, die Elektrodenstrukturen mit einer darüberliegenden Leiterplatte durch einfaches Einfügen von Leitgummistrukturen zu kontaktieren.

Weitere Merkmale und Vorteile der Erfindung ergeben sich aus der folgenden Beschreibung einer vorteilhaften Ausführungsform und aus den Zeichnungen, auf die Bezug genommen wird. In den Zeichnungen zeigen:
- Figur 1 eine perspektivische Ansicht eines Schaltergehäuses vor dem Einbringen von Elektrodenstrukturen;
- Figur 2 das Schaltergehäuse mit eingebrachten Elektrodenstrukturen;
- Figur 3 das Schaltergehäuse mit aufgelegter Leiterplatte; und
- Figur 4 eine Perspektivansicht eines unter Verwendung des Schaltergehäuses hergestellten kapazitiven Schalters.

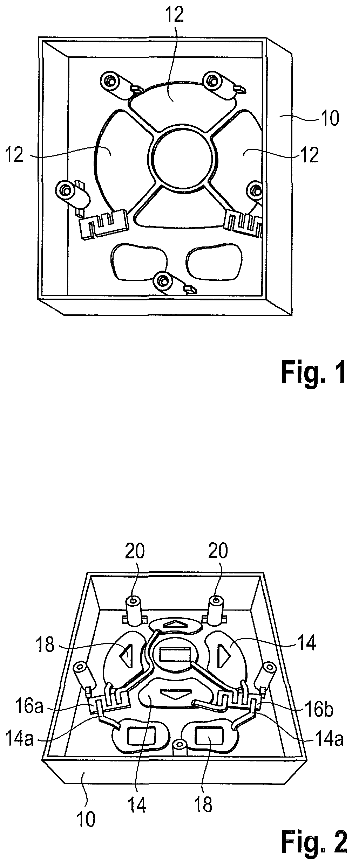

Das Schaltergehäuse für einen kapazitiven Schalter wird im Zweikomponenten-Spritzguss hergestellt. Figur 1 zeigt ein allgemein quaderförmiges Schaltergehäuse, das mit einer ersten, elektrisch nicht leitfähigen Kunststoffkomponente gespritzt ist, mit Blick auf die Innenseite. Die der Innenseite gegenüberliegende Stirnfläche des allgemein mit 10 bezeichneten Schaltergehäuses bildet eine Berührungsfläche des kapazitiven Schalters. Auf der gegenüberliegenden Innenseite ist die entsprechende Wandung mit flachen Ausnehmungen 12 ausgebildet. In diese Ausnehmungen wird im Zweikomponenten-Spritzguss eine zweite, elektrisch leitfähige Kunststoffkomponente eingebracht. Das Ergebnis ist in Figur 2 dargestellt. Die mit der zweiten Kunststoffkomponente gespritzten Strukturen sind elektrisch leitfähig und haben die Form der für den kapazitiven Schalter benötigten Elektrodenstrukturen. Diese Elektrodenstrukturen 14 haben angeformte Kontaktfahnen 14a, die zu einem an der Innenseite des Gehäusekörpers angeformten Kontaktierungsblock 16a bzw. 16b führen. Die Kontaktierungsblöcke 16a, 16b haben Ausnehmungen, in denen die Enden der Kontaktfahnen 14a positioniert sind. Die Kontaktierungsflächen an den Enden der Kontaktfahnen 14a liegen bündig in der Oberfläche der Kontaktierungsblöcke 16a, 16b. In Figur 2 ist ferner ersichtlich, dass die Elektrodenstrukturen 14 ausgesparte Fenster 18 aufweisen. An der Innenseite des Gehäusekörpers 10 sind ferner zylindrische Leiterplattenstützen 20 angeformt.

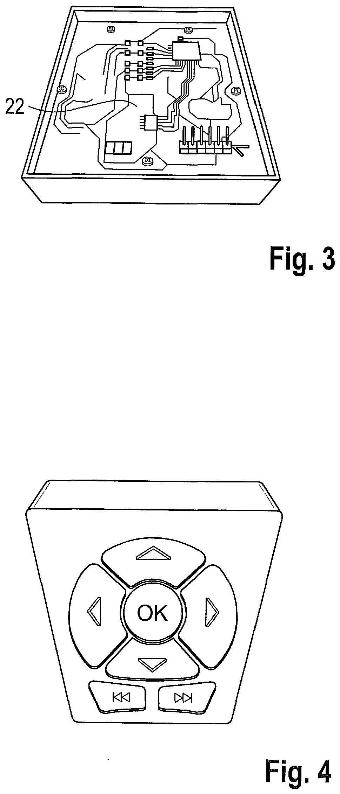

Bei dem in Figur 3 gezeigten Montagezustand ist eine Leiterplatte auf die Leiterplattenstützen 20 aufgelegt. Die Leiterbahnen der Leiterplatte 22 haben Kontaktierungsbereiche in Gegenüberlage zu den Kontaktierungsblöcken 16a, 16b. Die Verbindung der Elektrodenstrukturen 14 mit der Leiterplatte erfolgt durch zwischengelegte Leitgummielemente. Die Leiterplatte ist mit der Auswerteelektronik des kapazitiven Schalters bestückt.

Die in Figur 4 gezeigte Frontseite des fertigen kapazitiven Schalters ist mit Symbolen versehen, die den verfügbaren Schaltfunktionen zugeordnet sind. Die Symbole und Beschriftungen werden mittels Laserstrahl aus einer Lackschicht ausgeschnitten. Das darunterliegende Material des Schaltergehäuses ist aufgrund der Ausnehmungen 12 von verminderter Wandstärke und daher gut lichtdurchlässig. Durch auf der Leiterplatte 22 angeordnete Lichtquellen, insbesondere Leuchtdioden, werden die Symbole durch die Fenster 18 in den Elektrodenstrukturen 14 hindurch von der Innenseite des Schaltergehäuses her beleuchtet.

Ein bevorzugtes Kunststoffmaterial für die elektrisch nicht leitende erste Kunststoffkomponente, aus der der Gehäusekörper 10 gespritzt wird, ist Polycarbonat. Auch für die zweite Kunststoffkomponente, die elektrisch leitfähig sein muss, wird ein Polycarbonat gewählt, jedoch ein solches, das durch Beimischung von Kohlefasern elektrisch leitfähig ist. Beide Kunststoffe gehen durch den Zweikomponenten-Spritzguss eine innige Verbindung ein. Mit diesem Verfahren können auch die präzisen 3D-Strukturen geschaffen werden, die benötigt werden, um eine problemlos sichere Kontaktierung der Elektrodenstrukturen bis hin zur Leiterplatte in einem Massenherstellungsprozess zu gewährleisten. Der kapazitive Schalter ist aufgrund seiner Robustheit, Verschleißfreiheit und Korrosionsbeständigkeit gut geeignet zur Verwendung im Automobilbereich.

## Patentansprüche

1. Schaltergehäuse (10) für kapazitive Schalter, mit einer äußeren Berührungsfläche und innenseitig in Gegenüberlage zu der Berührungsfläche angeordneten flachen Elektrodenstrukturen, die im Zweikomponenten-Spritzguss in innenseitig in Gegenüberlage der Berührungsfläche angeordnete, ausgesparte Bereiche (12) des aus einer ersten, elektrisch nicht leitfähigen Kunststoffkomponente gespritzten Gehäusekörpers mit einer zweiten, elektrisch leitfähigen Kunststoffkomponente eingebracht sind, und bei dem die flachen Elektrodenstrukturen (14) mit angeformten Kontaktfahnen (14a) ausgebildet sind, die zu einem auf der Innenseite des Gehäusekörpers angeformten Kontaktierungsblock (16a, 16b) geführt sind, **dadurch gekennzeichnet, dass** die flachen Elektrodenstrukturen (14) ausgesparte Fenster (18) aufweisen und die Berührungsfläche gegenüber den ausgesparten Fenstern lichtdurchlässig ist, wobei eine Leiterplatte vorgesehen ist und wobei die Leiterplatte (22) mit Leuchtelementen bestückt ist, wobei die Leuchtelemente auf der Berührungsfläche des Schaltergehäuses angeordnete Symbole durch die ausgesparten Fenster (18) der Elektrodenstrukturen (14) und durch verdünnte Wandungsbereiche des Schaltergehäuses hindurch beleuchten.

2. Schaltergehäuse nach Anspruch 1, bei dem beide Kunststoffkomponenten ein Polycarbonat sind und die zweite Kunststoffkomponente Kohlefasern enthält.

3. Schaltergehäuse nach Anspruch 1, bei dem der Kontaktierungsblock (16a, 16b) Ausnehmungen aufweist, in denen die Enden der Kontaktfahnen (14a) positioniert sind und mit der Oberfläche des Kontaktierungsblocks (16a, 16b) bündige Kontaktierungsflächen bilden.

4. Schaltergehäuse nach einem der Ansprüche 1 bis 3, bei dem innenseitig an dem Gehäusekörper zylindrische Leiterbahnstützen (20) angeformt sind.

5. Kapazitiver Schalter mit einem Schaltergehäuse nach einem der Ansprüche 1 bis 4, bei dem die Leiterplatte mit Auswerteelektronik bestückt und am Boden des Schaltergehäuses angeordnet und mit den Elektrodenstrukturen (14) elektrisch verbunden ist.

## Claims

1. A switch housing (10) for capacitive switches, comprising an outer contact surface and flat electrode structures which are arranged on the inside in a position opposite the contact surface and are incorporated by two-component injection molding in recessed areas (12), arranged on the inside in a position opposite the contact surface, of the housing body injection molded from a first, electrically nonconductive plastic component using a second, electrically conductive plastic component, and wherein the flat electrode structures (14) are configured with integrally molded contact tabs (14a) which are led to a contacting block (16a, 16b) integrally molded on the inner surface of the housing body, **characterized in that** the flat electrode structures (14) have recessed windows (18) and the contact surface opposite the recessed windows is light-transmissive, wherein a circuit board is provided and wherein the circuit board (22) mounts light emitting elements, the light emitting elements illuminating symbols arranged on the contact surface of the switch housing through the recessed windows (18) of the electrode structures (14) and through thinned wall portions of the switch housing.

2. The switch housing according to claim 1, wherein both plastic components are a polycarbonate and the second plastic component contains carbon fibers.

3. The switch housing according to claim 1, wherein the contacting block (16a, 16b) has recesses in which the ends of the contact tabs (14a) are positioned and form contacting pads that are flush with the surface of the contacting block (16a, 16b).

4. The switch housing according to any of claims 1 to 3, wherein cylindrical conductor path supports (20) are integrally molded with the inner surface of the housing body.

5. A capacitive switch comprising a switch housing according to any of claims 1 to 4, wherein the circuit board mounts an evaluation electronics and is arranged at the bottom of the switch housing and is electrically connected to the electrode structures (14).

## Revendications

1. Boîtier de commutateur (10) pour des commutateurs capacitifs, présentant une surface de contact extérieure et des structures d'électrodes planes qui sont agencées du côté intérieur de manière à être opposées à la surface de contact et qui sont incorporées, par moulage par injection à deux composants, dans des zones évidées (12) agencées du côté intérieur dans une position opposée à la surface de contact, du corps de boîtier qui est moulé par injection à partir d'un premier composant plastique électriquement non-conducteur, avec un deuxième composant plastique électriquement conducteur, et dans lequel les structures d'électrode (14) planes sont réalisées avec des languettes de contact (14a) moulées sur celles-ci qui sont guidées vers un bloc d'établissement de contact (16a, 16b) moulé du côté intérieur du corps de boîtier, **caractérisé en ce que** les structures d'électrodes (14) planes présentent des fenêtres évidées (18) et **en ce que** la surface de contact en face des fenêtres évidées est transparente, une carte de circuits imprimés étant prévue, et la carte de circuits imprimés (22) étant équipée d'éléments lumineux, les éléments lumineux illuminant des symboles agencés sur la surface de contact du boîtier de commutateur à travers les fenêtres évidées (18) des structures d'électrode (14) et à travers des zones de paroi amincies du boîtier de commutateur.

2. Boîtier de commutateur selon la revendication 1, dans lequel les deux composants plastiques contiennent un polycarbonate et le deuxième composant plastique contient des fibres de carbone.

3. Boîtier de commutateur selon la revendication 1, dans lequel le bloc d'établissement de contact (16a, 16b) présente des creux dans lesquels les extrémités des languettes de contact (14a) sont positionnées et forment des surfaces d'établissement de contact en affleurement avec la surface du bloc d'établissement de contact (16a, 16b).

4. Boîtier de commutateur selon l'une des revendications 1 à 3, dans lequel des supports de piste conductrice (20) cylindriques sont moulés du côté intérieur avec le corps de boîtier.

5. Commutateur capacitif comprenant un boîtier de commutateur selon l'une des revendications 1 à 4, dans lequel la carte de circuits imprimés est équipée d'une électronique d'évaluation et est agencée au fond du boîtier de commutateur et est électriquement reliée aux structures d'électrode (14).
